Europäisches Patentamt

European Patent Office

Office européen des brevets

(11) Numéro de publication: **0 299 822**
**A1**

# DEMANDE DE BREVET EUROPEEN

(21) Numéro de dépôt: **88401604.9**

(22) Date de dépôt: **24.06.88**

(51) Int. Cl.⁴: **H 01 L 25/04**
**H 01 L 23/48**

(30) Priorité: **02.07.87 FR 8709379**

(43) Date de publication de la demande:
**18.01.89 Bulletin 89/03**

(84) Etats contractants désignés: **DE ES GB IT**

(71) Demandeur: **NEIMAN**
**39 Avenue Marceau**
**F-92400 Courbevoie (FR)**

(72) Inventeur: **Boucheron, Jean-Louis**
**6, Hameau du Rougeau**
**F-77176 Savigny-Le-Temple (FR)**

(74) Mandataire: **Lemaire, Marc**
**Société VALEO Département Propriété Industrielle 21,**
**rue Blanqui**
**F-93406 Saint-Ouen (FR)**

(54) **Procédé de fabrication d'un composant électronique de puissance et composants obtenus par ce procédé.**

(57) L'invention concerne un procédé de mise en parallèle de composants électroniques de puissance utilisant des pastilles de silicium portant des transistors MOS canal N et formant un composant de puissance importante. Le procédé selon l'invention est caractérisé par le fait que les grilles et les sources des transistors MOS sont mises en parallèle dans une même bande conductrice (4), la mise en parallèle des grilles s'effectue au moyen d'une fourche (2) faisant partie intégrante de ladite bande (4), la mise en parallèle des sources s'effectue au moyen d'une fourche (3) de ladite bande (4), l'ensemble de la bande (4) comprenant des points d'attache (5,6,7,8) qui sont sectionnés lors du montage.

Application à la commande électronique de puissance.

Figure 1

## Description

**Procédé de fabrication d'un composant électronique de puissance et composants obtenus par ce procédé.**

L'invention concerne un procédé de mise en parallèle de composants électroniques de puissance utilisant des pastilles de silicium portant des transistors MOS canal N et formant un composant de puissance importante.

Ce procédé permet d'obtenir des puissances dissipées plus élevées et/ou des caractéristiques plus performantes.

A cet effet, le procédé selon l'invention est caractérisé par le fait que les grilles et les sources des transistors MOS sont mises en parallèle dans une même bande conductrice, la mise en parallèle des grilles s'effectue au moyen d'une fourche faisant partie intégrante de ladite bande la mise en parallèle des sources s'effectue au moyen d'une fourche de ladite bande, l'ensemble de la bande comprenant des points d'attache qui sont sectionnés lors du montage.

Pour une application à un composant de puissance intelligent C.P.I., on met en parallèle de simples transistors MOS de puissance sur la partie puissance dudit composant de puissance intelligent C.P.I. possédant en outre une partie commande indépendante.

L'invention sera bien comprise à la lecture de la description suivante faite en se référant au dessin annexé dans lequel:

- la figure 1 est une vue schématique en perspective éclatée d'un composant selon un exemple de réalisation de l'invention, en cours de fabrication;

- la figure 2 est un schéma électrique d'un composant selon l'invention; et

- la figure 3 est un schéma électrique d'un composant selon l'invention utilisant un composant de puissance intelligent C.P.I.

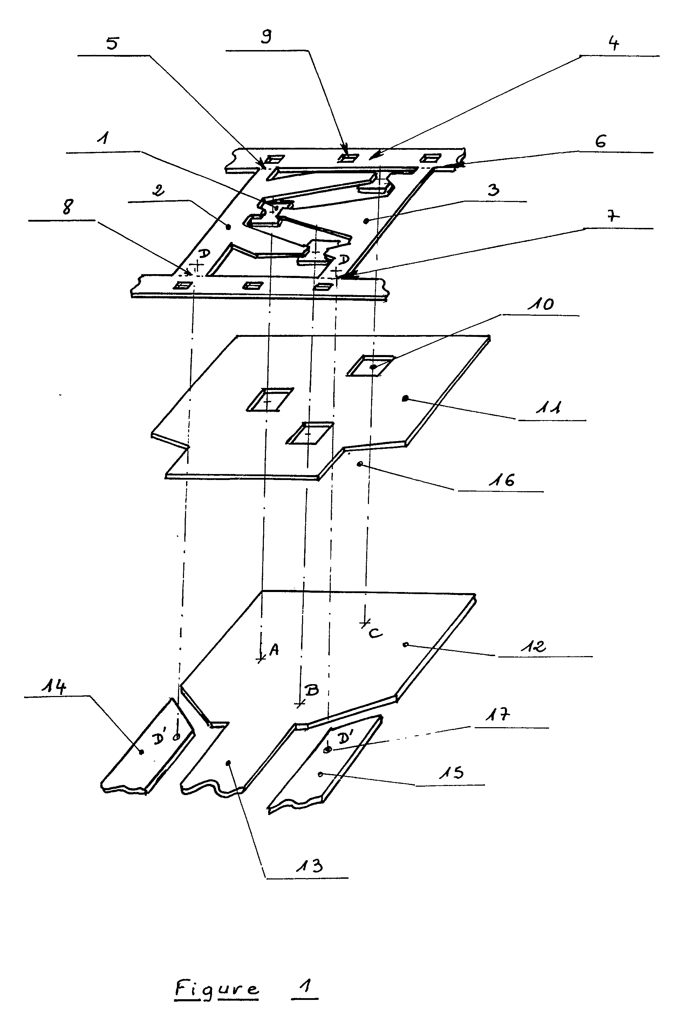

La figure 1 représente les pastilles de silicium 1 dont les grilles sont reliées entre elles par une partie de la bande conductrice fourche 2 alors que les sources sont reliées entre elles par une autre partie de la bande conductrice fourche 3. L'ensemble de la bande 4 est attelé aux parties reliant les liaisons entre transistors par quatre points d'attache 5, 6, 7 et 8 qui seront sectionnés lors du montage de ces composants de puissance associés en parallèle sur un substrat conducteur jouant également un rôle de refroidisseur.

La bande 4 portant les composants de puissance sous forme de pastilles de silicium 1 assemblées peut être positionnée à l'utilisation par des trous, échancrures, ou toute autre forme convenable 9.

Pour réaliser le composant de puissance composé des transistors assemblés, on utilise, après découpe de la bande 4, un support métallique en cuivre traité sur lequel on vient coller ou souder les pastilles de silicium sur les zones A, B, C à travers les fenêtres 10 d'un isolant 11 préalablement positionné sur le support métallique 12.

Ce support constitue le drain du transistor ainsi composé et peut comporter une languette de sortie 13.

Les deux autres sorties, réalisées par des languettes de sortie 14, 15 sont reliées chacune à une partie de la bande associée respectivement aux grilles et aux sources, à travers une fenêtre ou une échancrure 16 de l'isolant 11 par une liaison obtenue soit par une soudure électrique soit par l'application d'une thermode (point D relié au point D', 17).

Ce procédé permet de réaliser des composants de puissance pratiquement sans limitation de puissance. En effet, dans les procédés traditionnels, les limitations proviennent de la taille de la pastille de silicium qui, lorsque celleci augmente, conduit à des rendements de production peu élevés, ce qui augmente considérablement le prix du composant.

Dans le cadre de cette invention, un composant de puissance peut être réalisé à partir de plusieurs transistors ayant un coût raisonnable et permettre un assemblage dont le coût du composant global sera inférieur au coût d'un composant équivalent en technique monopuce.

De plus, cette technique est automatisable, elle permet d'adapter la section de passage de la bande aux densités de courant désirées. Elle répartit la puissance dissipée par puce permettant d'obtenir globalement une meilleure résistance thermique jonction boitier. Enfin, la surface du substrat peut être choisie de façon à obtenir une bonne répartition des calories tout en prévoyant son adaptation et intégration dans l'utilisation envisagée.

La figure 2 représente schématiquement l'association réalisée par le procédé sur des transistors MOS où les drains sont reliés entre eux par le substrat 18 alors que les sources 20 et les grilles 19 sont reliées par la bande conductrice porteuse de pastilles.

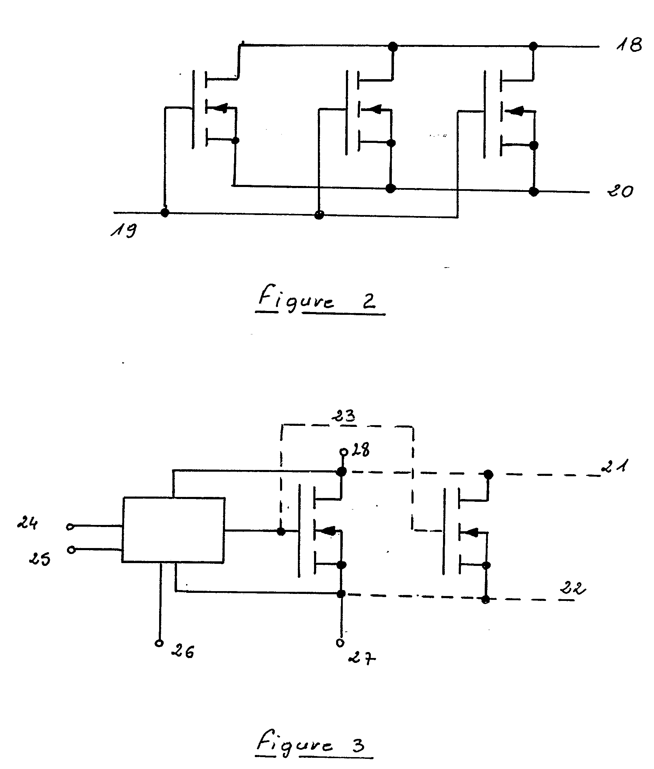

La figure 3 représente une autre application du procédé dans le cadre d'une utilisation d'un composant de puissance intelligent (CPI) pour lequel on désire augmenter la puissance commandée.

Pour cela, de la même manière que précédemment, les transistors sont reliés par les drains, ou substrat métallique 21, les grilles 23 ainsi que les sources 22 sont reliées entre elles par la bande conductrice porteuse des pastilles silicium.

Dans cette application, il convient de prévoir également d'autres sorties uniques telles que l'entrée de commande 24, le fil d'état 25, la masse 26.

La liaison sources 22 sera sortie sur une languette utilisation 27 et la liaison drain 21 sera sortie sur une languette 28.

Au contraire, la liaison grille 23 sera uniquement interne au nouveau composant ainsi constitué.

## Revendications

1.- Procédé de mise en parallèle de composants électroniques de puissance utilisant des pastilles de silicium portant des transistors MOS canal N et formant un composant de puissance importante, caractérisé par le fait que les grilles et les sources des transistors MOS sont mises en parallèle dans une même bande conductrice (4), la mise en parallèle des grilles s'effectue au moyen d'une fourche (20) faisant partie intégrante de ladite bande (4) la mise en parallèle des sources s'effectue au moyen d'une fourche (3) de ladite bande (4), l'ensemble de la bande (4) comprenant des points d'attache (5,6,7,8) qui sont sectionnés lors du montage.

2.-Procédé selon la revendication 1, pour un composant de puissance intelligent C.P.I., caractérisé par le fait qu'on met en parallèle de simples transistors MOS de puissance sur la partie puissance dudit composant de puissance intelligent C.P.I. possédant en outre une partie commande (24,25,26) indépendante.

3.- Composant électronique de puissance, caractérisé par le fait qu'il est obtenu par le procédé selon l'une des revendications 1 et 2.

0299822

Figure 1

0299822

Figure 2

Figure 3

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| Y | GB-A-2 135 824 (SGS-ATES)<br>* En entier *<br>--- | 1,3 | H 01 L 25/04<br>H 01 L 23/48 |
| Y | EP-A-0 154 187 (OLIN)<br>* Figure 1; page 9, ligne 26 - page 10, ligne 15 *<br>--- | 1,3 | |
| A | EP-A-0 058 852 (SIEMENS)<br>--- | | |
| A | PATENT ABSTRACTS OF JAPAN, vol. 6, no. 123 (E-117)[1001], 8 juillet 1982, page 4 E 117; & JP-A-57 49 256 (TOKYO SHIBAURA DENKI K.K.) 23-03-1982<br>----- | | |

DOMAINES TECHNIQUES
RECHERCHES (Int. Cl.4)

H 01 L

Le présent rapport a été établi pour toutes les revendications

| Lieu de la recherche | Date d'achèvement de la recherche | Examinateur |
|---|---|---|
| LA HAYE | 05-10-1988 | CAMPLING N.C.G. |